# EUROPEAN PATENT SPECIFICATION

(11) **EP 0 252 151 B1**
(45) Date of publication and mention of the grant of the patent: **14.04.1993**
(21) Application number: 86900628.8
(22) Date of filing: 06.01.1986
(51) Int. Cl.: G03F 7/12, C08F 8/30, C08F 299/00, C08L 29/04

(54) **PHOTOSENSITIVE MATERIAL FOR SCREEN PROCESS**
LICHTEMPFINDLICHES MATERIAL FÜR SCHABLONENDRUCK
MATERIAU PHOTOSENSIBLE POUR SERIGRAPHIE

(43) Date of publication of application: 13.01.1988
(73) Proprietor: Japan as represented by Director-General, Agency of Industrial Science and Technology, Tokyo 100 (JP); DAICEL CHEMICAL INDUSTRIES, LTD., Sakai-shi Osaka-fu 590 (JP)
(72) Inventor: ICHIMURA, Kunihiro, Tsukuba-gun Ibaraki-ken 305 (JP); KUBO, Keiji, Ibo-gun Hyogo-ken 671-15 (JP)
(74) Representative: Grünecker, Kinkeldey, Stockmair & Schwanhäusser Anwaltssozietät
(86) International application number: JP8600002
(87) International publication number: WO8704272

(56) References cited:
- EP-A- 0 092 901
- JP-A- 5 562 446
- JP-A-58 194 905
- PATENT ABSTRACTS OF JAPAN vol. 7, no. 256 (P-236)(1401) 15 November 1983
- PATENT ABSTRACTS OF JAPAN vol. 8, no. 219 (P-306)(1656) 05 October 1984

## Description

The present invention relates to a photosensitive material for screen processing capable of forming a water-developable, highly sensitive coating film having excellent water and solvent resistances.

Screen printing has various advantages such as, for example easy printing operation, high image accuracy, freeness from strict limitation with respect to print base and large building-up of an applied ink. Thus, it is employed in diverse fields, while it is expanding its scope of application fields with a rapidly increasing demand therefor.

The so-called direct process for producing a screen plate comprises applying a photosensitive emulsion prepared by mixing a photosensitive agent such as a dichromate or a diazo resin with polyvinyl alcohol and a polyvinyl acetate emulsion to a screen made of a polyester or a nylon which is stuck on a frame to form a photosensitive coating film. In the direct process, however, the application step disadvantageously takes a long time, provides a large variation of the thickness of the coating film and a lack of smoothness of the coating film surface entailing a reduced resolution because of the repetition of manual application work and drying.

As a result of investigations with a view to obviating the disadvantages of the above-mentioned conventional process comprising directly applying a photosensitive emulsion onto a surface of a screen to form a coating film, the inventor of the present invention found that a procedure comprising the preparation of a photosensitive material for screen processing by coating a plastic film with a photosensitive emulsion, sticking of the photosensitive material to the surface of a screen with the aid of water of a photosensitive emulsion, and removal of the plastic film after drying, can curtail the working steps and provide a uniform thickness of the coating film on the surface of a screen to materialize a screen printing plate with a very high accuracy. Based on this finding, the inventor disclosed an invention in Japanese Patent Laid-Open No. 85,048/1982.

However, the coating film obtained in accordance with the previous proposal involves a problem of water resistance which obstructs printing with e.g. a water ink. With a view to solving the problem, the inventor of the present invention previously found that a photosensitive material comprising a plastic film, a photosensitive resin composition (I) comprising a water-soluble or water-dispersible polymer or copolymer, an unsaturated compound having a photo-polymerizable ethylenic double bond, a photo-reaction initiator applied to the plastic film, and a photosensitive resin composition (II) comprising polyvinyl alcohol, a polyvinyl acetate emulsion, and a diazo compound and applied to the composition (I). Based on this finding, the inventor disclosed an invention in Japanese Patent Laid-Open No. 139, 143/1983.

Since the sensitivity of the photosensitive resin composition (II) is considerably lower than that of the photosensitive resin composition (I), however, the procedure must be adapted to the sensitivity of the photosensitive resin composition (II). Thus, the photosensitive material for screen processing of the above-mentioned invention is defectively low in sensitivity as a whole. JP-A_58-139143 discloses a photosensitive material for screen processing obtained by coating a photosensitive composition consisting of a water-soluble or water-dispersible (co)polymer such as polyethylene oxide or a homo- or copolymer of acrylic acid, an unsaturated compound having a polymerizable ethylenic double bond such as a vinyl monomer having a (meth)acrylic group, an allyl group or the like or a vinyl prepolymer, a photopolymn. initiator such as anthraquinone on a plastic film in ≧5µm thickness and by further coating a photosensitive composition consisting of PVA, a polyvinyl acetate emulsion, and a diazo compound in ≧ 10µm thickness.

The inventor of the present invention has completed the present invention as a result of intensive investigations with a view to solving the above-mentioned problems.
The object of the present invention is to provide a photosensitive material for screen processing capable of forming a coating film which is water-soluble and highly sensitive, which allows a water ink to be used, and which is utilizable as a PS plate for screen processing.

The photosensitive material for screen processing of the present invention, which has attained the above-mentioned object, comprises a photosensitive resin composition (A) applied to a plastic film, and including a water-soluble or water-dispersible polymer or copolymer, an unsaturated compound having a photopolymerizable ethylenic double bond, and a photopolymerization initiator, and a photosensitive resin composition (B) applied in a thickness of at least 0.1 µm to the coated composition (A) and including a film-forming polymeric compound characterised in that the photosensitive resin composition (B) further includes a photo-crosslinkable polyvinyl alcohol containing 0.5 to 10 mol% of a photo-crosslinkable unit having the general formula (III): 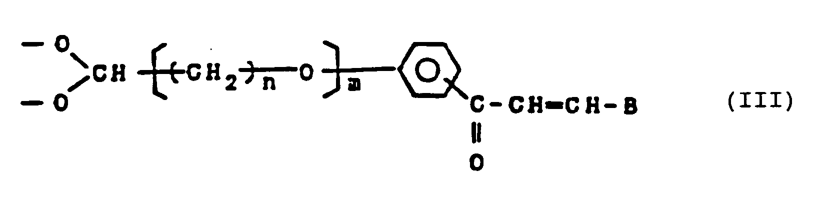
wherein B is an aromatic or heterocyclic group having at least one kind of polar group; m is an integer of 0 or 1, and n is an integer of 1 to 6;
and wherein the polyvinyl alcohol used for preparing the photo-crosslinkable polyvinyl alcohol has a degree of saponification of 75 mol% or more and a degree of polymerization of 300 to 3,000.
In one embodiment of the present invention the photosensitive material which is defined as above further contains a photo-crosslinkable unit of general formula (I) and /or (II): 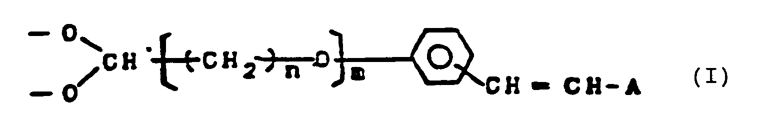
wherein A is selected from groups represented by the general formula (1) or (2) attached to the unit of general formula (I) at any carbon atom of the aromatic ring except a substituted carbon atom: 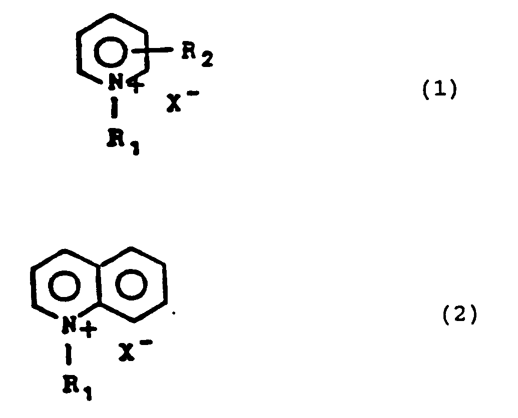
wherein R₁ is a hydrogen atom, or an alkyl or aralkyl group which may contain a hydroxyl group, a carbamoyl group, ether or unsaturated groups; R₂ is a hydrogen atom or a lower alkyl group; and x⁻ is an anion, m is an integer of 0 or 1, and n is an integer of 1 to 6: 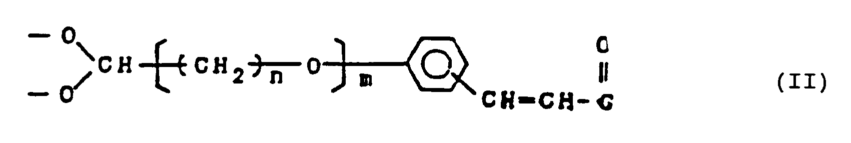
wherein B is defined as in general formula (III).

The water-soluble or water-dispersible polymer or copolymer to be used in the photosensitive resin composition (A) include synthetic polymeric compounds such as polyethylene oxide, acrylic acid homopolymers and copolymers, acrylamide homopolymers and copolymers, maleic acid homopolymers and copolymers, vinyl acetate homopolymers and copolymers and their hydrolyzates, vinylpyrrolidone homopolymers and copolymers, vinylpyridine homopolymers and copolymers, and water-soluble polyamides; semi-synthetic polymeric compounds such as ethylcellulose, hydroxypropylcellulose, and carboxymethylcellulose; and natural polymeric compounds such as gelation and alginic acid.

The unsaturated compound having a photopolymerizable ethylenic double bond that is used in the present invention is preferably soluble in water and/or a liquid mixture of water and an organic solvent and preferably well compatible with a homopolymer or copolymer as mentioned above. Such compounds include vinyl monomers or vinyl prepolymers having 1 to 3 polymerizable ethylenic double bonds derived from among e.g. acryl, methacryl, allyl, vinyl ether and acrylamide groups.

Photopolymerization initiators usable in the present invention include anthraquinones, benzophenones, benzoins, benzils, diazonium compounds, and azide compounds.

The ratio of the polymer or copolymer : the unsaturated compound : photopolymerization initiator in the photosensitive resin composition (A) to be used in the present invention is preferably 30 to 90 : 70 to 10 : 0.01 to 10 in terms of parts by weight. Other arbitrary components such as a thermal polymerization inhibitor may be incorporated.

The film-forming polymeric compound to be used in the photosensitive resin composition (B) in the present invention may be used in the form of an emulsion containing the same. Usable emulsions include those of vinyl acetate, acrylic, ethylene-vinyl acetate, ethylene-acrylic, vinyl chloride and vinylidene chloride, and an SBR (styrene butadiene rubber) latex.

The photo-crosslinkable polyvinyl alcohol to be used in the present invention is obtained by introducing the above-mentioned photo-crosslinkable unit represented by the general formula (III) optionally in combination with (I) and/or (II) into a polyvinyl alcohol prepared by completely or partially saponifying a polyvinyl acetate. Introduction of the photo-crosslinkable unit represented by the general formula (III) optionally in combination with (I) and/or (II) can be effected by a known method such as one disclosed in Japanese Patent Publication No. 5,761/1981 or 5,762/1981, or Japanese Patent Laid-Open No. 194,905/1983. The method of synthesis of the polyvinyl alcohol containing photo-crosslinkable units of the formula (I) will be described as the representative example. Specifically, polyvinyl alcohol is reacted in the presence of an acid catalyst with a stilbazolium or styrylquinolinium salt compound, respectively, represented by a general formula (IV) or (V): 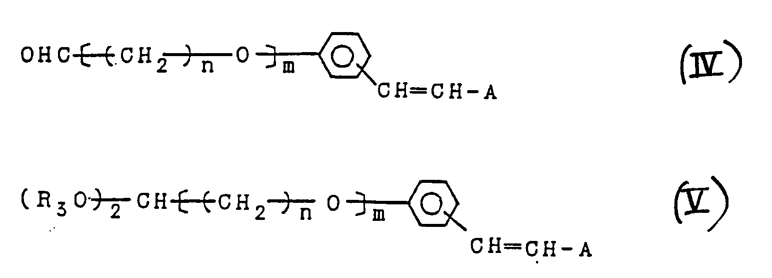
(wherein A, m, and n are as defined above; and R₃ is a lower alkyl group, or two R₃ groups constitute an alkylene group),
whereby a photo-crosslinkable polyvinyl alcohol having the stilbazolium or styrylquinolinium groups introduced thereinto is obtained.

Examples of the compound represented by the general formula (IV) include 1-methyl-2-(p-formylstyryl)pyridinium, 1-methyl-4-(p-formylstyryl)pyridinium, 1-ethyl-2-(p-formylstyryl)pyridinium, 1-ethyl-4-(p-formylstyryl)pyridinium, 1-allyl-4-(p-formylstyryl)pyridinium, 1-(2-hydroxyethyl)-2-(p-formylstyryl)pyridinium, 1-(2-hydroxyethyl)-4-(p-formylstyryl)pyridinium, 1-carbamoylmethyl-2-(p-formylstyryl)pyridinium, 1-carbamoylmethyl-4-(p-formylstyryl)pyridinium, 1-methyl-2-(m-formylstyryl)pyridinium, 1-benzyl-2-(p-formylstyryl)pyridinium, 1-benzyl-4-(p-formylstyryl)pyridinium,1-methyl-4-(p-formylstyryl)-5-ethylpyridinium, 1-methyl-2-(p-formylstyryl)quinolinium, 1-ethyl-2-(p-formylstyryl)quinolinium, and 1-ethyl-4-(p-formylstyryl)quinolinium.

The acetal compound of the formyl compound represented by the general formula (IV) may be used as the compound represented by the general formula (V). Usable anions represented by X⁻ include halogen, phosphate, sulfate, methosulfate, and p-toluenesulfonate ions.

Examples of the aromatic or heterocyclic group B having a polar group in the photo-crosslinkable unit represented by the general formula (II) or (III) include those substituted with a carboxylic acid or its salt, a sulfonic acid or its salt, or a primary, secondary, tertiary amine or its salt including a quaternary salt of a tertiary amine.

Polyvinyl alcohol used in the preparation of the photo-crosslinkable polyvinyl alcohol has a degree of saponification of 75 mol % or more. The content of the photo-crosslinkable units in the alcohol is 0.5 to 10 mol %. Too large a content will increase the viscosity of the reaction product, thus making the preparation thereof difficult. Furthermore, the water solubility of the obtained photosensitive resin composition becomes insufficient.

The ratio of the film-forming polymeric compound to the photo-crosslinkable polyvinyl alcohol in the photosensitive resin composition (B) in the present invention is preferably in the range of 100 parts by weight : 10 to 200 parts by weight.

The photosensitive resin composition (B) for screen processing to be used in the present invention exhibits a high sensitivity even with a small amount of the photo-crosslinkable units, and is not affected by oxygen in air.

The thickness of the photosensitive resin composition (B) is determined according to the purpose. When the photosensitive resin composition (B) is used as the protective layer for the photosensitive resin composition (A), a thickness of the photosensitive resin composition (B) of at least 0.1 µm will suffice. In this case, however, the screen cannot be reproduced. Where reproduction is necessary, the thickness of the photosensitive resin composition (B) must be at least 10 µm.

Even if the photosensitive resin composition (B) is replaced by a non-photosensitive resin composition (B') such as a system of polyvinyl alcohol alone, the performance of the composition as a protective layer can be exhibited. However, the printing resistance is largely affected since the portion consisting of the photosensitive or non-photosensitive resin composition (B or B') corresponds to one bitten inward by a screen when the photosensitive material is applied to the screen. In other words, when a non-photosensitive resin composition (B') is used, the printing resistance is insufficient, and a photosensitive material for screen processing capable of allowing a screen to be reproduced cannot be prepared.

A small amount of an adequate dye may be incorporated into the above-mentioned photosensitive resin compositions (A) and (B), for example, in order to facilitate the inspection of pinholes. in an image formed by light exposure and development. In order to improve the various performance characteristics of the film, small amounts of a plasticizer, a surface-active agent, a lubricant, a fine powder, and various additives may be added.

Methods of obtaining the photosensitive material for screen processing of the present invention from the photosensitive resin compositions (A) and (B) include a method which comprises applying the photosensitive resin composition (A) to a film selected from among various plastic films such as polyethylene terephthalate, polypropylene, polycarbonate, polyvinyl chloride, and cellulose acetate films by an ordinary technique, and applying thereto the photosensitive resin composition (B) in one layer.

An alternative method comprises layer-wise casting and drying the compositions on a surface of a heated drum or a heated endless belt by an ordinary solution casting technique to prepare film sheets and sticking them to a plastic film as mentioned above to form a laminate.

As described above, since the photosensitive resin composition (B) is provided on the anaerobic photosensitive resin composition (A) without fail, neither is a cover film, for example, needed, nor does a reduction of the sensitivity occur. Due to the absence of any difference in the sensitivity between the photosensitive resin compositions (A) and (B), which are both highly sensitive, a wide latitude of light exposure results.

The above-described photosensitive material for screen processing of the present invention can curtail the steps of the direct method and compensate for the defects of the indirect method. The obtained screen printing plate is developable with water and is highly sensitive, exhibits an excellent resolution, water resistance, solvent resistance, film strength and printing resistance, while the edge of a pattern formed is sharp. Thus, beautiful and precise prints can be obtained. The used pattern can be subjected to a reproduction of a screen.

The photosensitive material for screen processing of the present invention may be applied to a screen, dried, and stored in the dark without causing peeling of the plastic film. In this case, the resulting material can be used as a presensitized plate.

### Brief Description of the Drawings

Figs. 1, 2, and 3 are illustrative views showing the steps of the production of a screen printing plate from the photosensitive material for screen processing of the present invention by the direct method. Figs. 4 and 5 are illustrative views showing the steps of the production of a screen printing plate in the same way but by the indirect method.
Explanation of symbols:
1. plastic film
2. photosensitive resin composition (A)
3. photosensitive resin composition (B)
4. photosensitive material for screen processing
5. screen plate
6. squeegee
7. applied photosensitive layer

### Examples

Examples of the method of using the photosensitive material for screen processing of the present invention will be described with reference to the drawings.
(a) According to the direct method; Fig. 1 shows a photosensitive material (4) for screen processing formed by application of the photosensitive resin compositions (A)(2) and (B)(3) in uniform thicknesses to a plastic film (1) and drying the same. The photosensitive material (4) was cut into an adequate size, wetted with water, and contact-bonded to a preliminarily prepared screen plate (5) with a squeegee (6) as shown in Fig. 2.
   Alternatively, the photosensitive material (4) was superposed on a screen plate (5), the plate (5) was uniformly wetted on its surface by water with, for example, a sponge or a spray, followed by contact-bonding by squeezing with a squeegee (6) as shown in Fig. 2. The obtained screen plate was well dried by cool air or warm air of 50°C or lower. Thereafter, the plastic film (1) was stripped as shown in Fig. 3 to form a screen printing plate.
(b) According to the indirect method; A photosensitive emulsion composed of a film-forming polymeric compound and a photo-crosslinkable polyvinyl alcohol as used in the photosensitive resin composition (B) or other photosensitive emulsion for screen processing was applied to a screen plate (5) with a squeegee bat in the same manner as in the direct method to form a photosensitive layer (7) as shown in Fig. 4. Subsequently, a photosensitive material (4) for screen processing was contact-bonded onto a non-dried photosensitive layer (7) with a squeegee (6) in the same manner as in (a) above, as shown in Fig. 5. The subsequent steps are the same as in (a) above.
   The following Examples will illustrate the present invention in more detail.

### Referential Example 1

110 g of N-methyl-γ-picolinium methosulfate and 200 g of terephthalaldehyde were dissolved in 400 ml of methanol under heating, and admixed with 6 ml of piperizine, followed by reflux for 3 h. After cooling, ethanol was distilled off under reduced pressure, and washing was effected with ethyl acetate. The precipitate obtained was dissolved in hot ethanol, and slowly admixed with ethyl acetate to precipitate crystals, which were then washed with ethyl acetate and dried to obtain 120 g of N-methyl-γ-(p-formylstyryl)pyridinium methosulfate.

### Referential Example 2 (preparation of photo-crosslinkable polyvinyl alcohol (i))

9 g of N-methyl-γ-(p-formylstyryl)pyridinium methosulfate obtained in Referential Example 1 and 100 g of polyvinyl alcohol having a degree of saponification of 88 mol % and a degree of polymerization of 1,700 were dissolved in 900 ml of water under heating. 5 g of 85 % phosphoric acid were added to the resulting solution, and the resulting mixture was heated at 60°C for 5 h with stirring, followed by stirring at ordinary temperature for one day. The reaction mixture was poured into a large amount of acetone to precipitate a resin, which was twice sufficiently washed with methanol, and dried to obtain 98 g of the washed resin. The stilbazolium group content of the total polymer units of polyvinyl alcohol was about 1.2 mol %.

### Referential Example 3 (preparation of photo-crosslinkable polyvinyl alcohol (ii))

30 g of N-methyl-γ-(p-formylstyryl)pyridinium methosulfate were reacted with 100 g of polyvinyl alcohol having a degree of saponification of 88% and a degree of polymerization of 500 in the same manner as in Referential Example 3 to obtain 105 g of a resin. The stilbazolium group content of the resin was about 3.5 mol %.

### Example 1

Photosensitive resin composition dispersions (A-1) and (B-1) having the following compositions were prepared.

| Photosensitive Resin Composition Dispersion (A-1): | |
|---|---|
| partially saponified polyvinyl alcohol (average degree of polymerization: 500, degree of saponification: 80 mol %) | 10 parts by weight |
| benzoin isopropyl ether | 0.25 part by weight |
| trimethylolpropane trimethacrylate | 0.8 part by weigt |
| β-hydroxyethyl methacrylate | 10 parts by weight |
| water | 80 parts by weight |

| Photosensitive Resin Composition Dispersion (B-1): | |
|---|---|
| photo-crosslinkable polyvinyl alcohol (i) (obtained in Referential Example 2) | 10 parts by weight |
| polyvinyl acetate emulsion (solids concentration: 50 wt.%) | 20 parts by weight |
| water | 70 parts by weight |

The photosensitive resin composition dispersion (A-1) was applied to a surface of a biaxially stretched polyester film having a thickness of 75 µm by means of a bar coater, and dried with hot air of 60°C to form a photosensitive coating film having a thickness of 30 µm. The photosensitive resin composition dispersion (B-1) was then applied thereto and dried to form a coating film having a thickness of 1 µm. Thus, a photosensitive material for screen processing was obtained.

The photosensitive material was stuck to a 105 µm (150 mesh) polyester screen stretched in a wooden frame by the method (a) described above as one alternative of the method of using the photosensitive material for screen processing, (directed method), and dried by draft. When the polyester film was stripped, the photosensitive layer was bitten by the screen up to about 10 µm.

Subsequently, the screen was closely contacted with a positive original, exposed to light at a distance of 1 m from a 3 kW ultra-high pressure mercury lamp for 30 s, washed with a shower of ordinary temperature water to effect development, and dried to obtain a screen printing plate having an excellent edge sharpness and including fine lines reproduced up to a line width of 100 µm. Printing was carried out using the screen printing plate to obtain over 10,000 prints which were very sharp and had a good image reproducibility.

### Example 2

The photosensitive resin composition dispersion (A-1) was applied to a biaxially stretched polyester film to form a photosensitive coating film having a thickness of 20 µm. The photosenstive resin composition dispersion (B-1) was then applied thereto and dried to form a coating film having a thickness of 20 µm. Thus, a photosensitive material for screen processing was obtained.

The obtained photosensitive film for screen processing was stuck to a 63 µm (250-mesh) polyester screen stretched in a wooden frame with the aid of water and dried by draft, followed by stripping of the polyester film.

The photosensitive layer was bitten up to about 25 µm.

Subsequently, the screen plate was closely contacted with a positive original, exposed to light at a distance of 1 m from a 3 kW ultra-high pressure mercury lamp for 40 s, washed with a shower of ordinary temperature water to effect development, and dried to obtain a pinhole-free screen printing plate having an excellent edge sharpness and including fine lines reproduced up to a line width of 100 µm. After printing, the plate was treated with a commercially available film stripping solution which is used as an emulsion for the direct method. The film was perfectly stripped to reproduce a screen.

### Example 3

A dispersion (A-2) having the following composition was prepared instead of the photosensitive resin composition dispersion (A-1), from which a coating film having a thickness of 20 µm was formed on a biaxially stretched polyester film in the same manner as in Example 1.

| Photosensitive Resin Composition Dispersion (A-2): | |
|---|---|
| hydroxypropylcellulose (MS (molar number of substitution) of hydroxypropyl group: 3, viscosity of a 2.2% aqueous solution : 7 cP (20°C)) | 20 parts by weight |
| triethylene glycol diacrylate | 4 parts by weight |
| diethylene glycol diacrylate | 4 parts by weight |
| benzoin methyl ether | 0.4 part by weight |
| methylene chloride/methanol: | 1/100 (parts by weight) |

The photosensitive resin composition dispersion (B-1) was applied thereto in a thickness of 0.5 µm, and dried to form a photosensitive material. The photosensitive resin composition dispersion (B-1) adjusted to have a solids concentration of 30 wt.% was applied once by means of a squeegee bat on a 49 µm (300-mesh) polyester screen, on which the above-mentioned photosensitive material was superposed, followed by contact bonding by means of a squeegee. After drying was effected by draft and the polyester film was stripped, the photosensitive layer was bitten up to about 10 µm. Subsequently, the film of the photosensitive layer was closely contacted with a positive original, exposed to light at a distance of 1 m from a 4 kW ultra-high pressure mercury lamp for 20 s, immersed in ordinary-temperature water to dissolve out most of the unexposed portion, and ejected with water by means of a spray gun for the purpose of completely removing the unexposed portion to effect development, and dried with warm air of 45°C to prepare a screen printing plate, which had an excellent edge sharpness and included fine lines reproduced up to a line width of about 60 µm. The screen was reproduced with a film stripping solution in the same manner as in Example 2.

### Example 4

A photosensitive material was obtained in the same manner as in Example 1 except that the photosensitive resin composition dispersion (B-2) was used instead of the photosensitive resin composition dispersion (B-1).

| Photosensitive Resin Composition Dispersion (B-2) | |
|---|---|
| photo-crosslinkable polyvinyl alcohol (ii) (obtained in Referential Example 3) | 10 parts by weight |
| polyvinyl acetate emulsion (solids concentration: 50 wt.%) | 30 parts by weight |
| water | 85 parts by weight |

Exposure to light and development were carried out in the same manner as in Example 1 to obtain a screen printing plate having a high-fidelty image.

## Claims

1. A photosensitive material for screen processing comprising:
a photosensitive resin composition (A) applied to a plastic film, and including a water-soluble or water-dispersible polymer or copolymer, an unsaturated compound having a photopolymerizable ethylenic double bond, and a photopolymerization initiator;
and a photosensitive resin composition (B) applied in a thickness of at least 0.1µm to the coated composition (A) and including a film-forming polymeric compound, **characterised in that** the photosensitive resin composition (B) further includes a photo-crosslinkable polyvinyl alcohol containing 0.5 to 10 mol% of a photo-crosslinkable unit having the general formula (III): 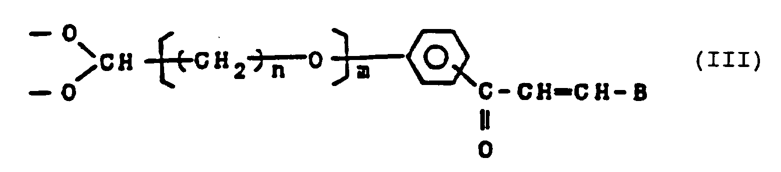 wherein B is an aromatic or heterocyclic group having at least one kind of polar group; m is an integer of 0 or 1, and n is an integer of 1 to 6;
and wherein the polyvinyl alcohol used for preparing the photo-crosslinkable polyvinyl alcohol has a degree of saponification of 75 mol% or more and a degree of polymerization of 300 to 3,000.

2. The photosensitive material of claim 1, wherein the photo-crosslinkable polyvinyl alcohol further contains a photo-crosslinkable unit having the general formula (I) and/or (II): 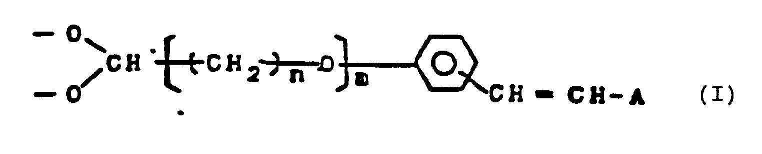 wherein A is selected from groups represented by the general formulae (1) or (2) 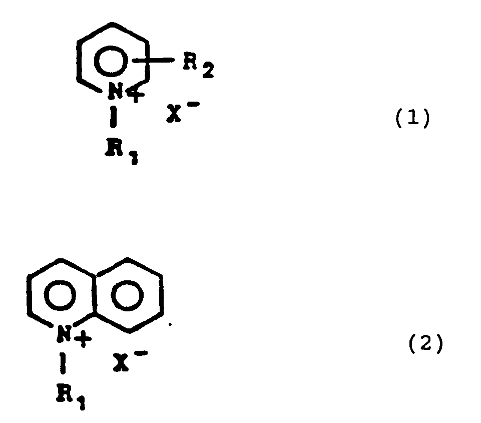 wherein R₁ is a hydrogen atom, or an alkyl or aralkyl group which may contain a hydroxyl group, a carbamoyl group, an ether group or an unsaturated group; R₂ is a hydrogen atom or a lower alkyl group; and x⁻ is an anion;
m is an integer of 0 or 1, and n is an integer of 1 to 6; 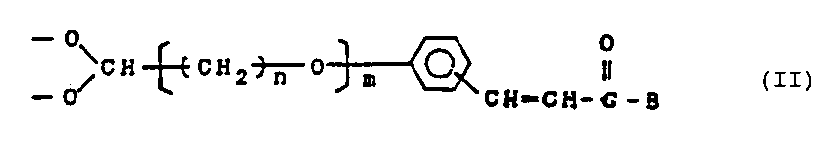 wherein B is defined as in general formula (III).

3. The photosensitive material of claim 1 or 2, **characterised in that** B of the general formula (II) or (III) is an aromatic or heterocyclic group substituted with a carboxylic acid or its salt, a sulfonic acid or its salt, or a primary, secondary, tertiary amine or its salt including a quaternary salt of a tertiary amine.

4. The photosensitive material of any of claims 1 to 3, **characterised in that** the ratio of the film-forming polymeric compound to the photo-crosslinkable polyvinyl alcohol in the photosensitive resin composition (B) is 100 parts by weight: 10 to 200 parts by weight.

## Patentansprüche

1. Lichtempfindliches Material für ein Siebdruckverfahren, umfassend:
- eine auf einen Plastikfilm aufgetragene lichtempfindliche Harzzusammensetzung (A), die ein wasserlösliches oder ein wasserdispergierbares Polymer oder Copolymer, eine ungesättigte Verbindung mit einer photopolymerisierbaren ethylenischen Doppelbindung und einen Photopolymerisationsinitiator enthält;
- und eine auf die aufgetragene Zusammensetzung (A) mit einer Dicke von mindestens 0,1 µm aufgetragene lichtempfindliche Harzzusammensetzung (B), die eine Film-bildende Polymerverbindung enthält,
**dadurch gekennzeichnet**, daß die lichtempfindliche Harzzusammensetzung (B) weiterhin einen lichtvernetzbaren Polyvinylalkohol enthält, der 0,5 bis 10 Mol% einer lichtvernetzbaren Struktureinheit mit der allgemeinen Formel (III): 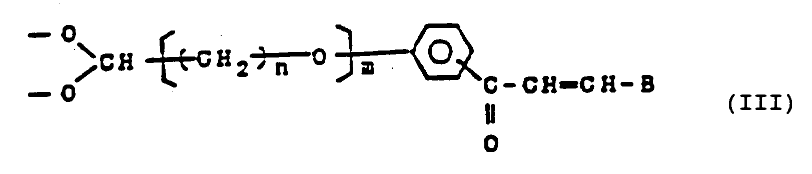 enthält, worin B eine aromatische oder heterocyclische Gruppe mit mindestens einer polaren Gruppe ist; m eine ganze Zahl von 0 oder 1 und n eine ganze Zahl von 1 bis 6 ist;
und worin der Polyvinylalkohol, der zum Herstellen des lichtvernetzbaren Polyvinylalkohols verwendet wird, einen Verseifungsgrad von 75 Mol% oder mehr und einen Polymerisationsgrad von 300 bis 3000 hat.

2. Lichtempfindliches Material nach Anspruch 1, worin der lichtvernetzbare Polyvinylalkohol weiterhin eine lichtvernetzbare Struktureinheit mit der allgemeinen Formel (I) oder (II) enthält: 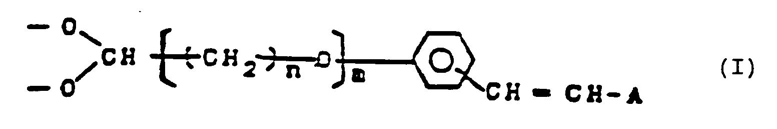 worin A ausgewählt ist aus den durch die allgemeine Formel (1) oder (2) dargestellten Gruppen 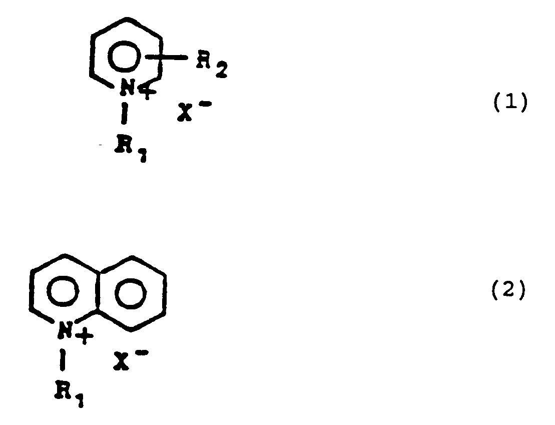 worin R₁ ein Wasserstoffatom oder eine Alkyl- oder eine Aralkylgruppe ist, die eine Hydroxylgruppe, eine Carbamoylgruppe, eine Ethergruppe oder eine ungesättigte Gruppe enthalten kann; R₂ ein Wasserstoffatom oder eine niedrige Alkylgruppe ist; und X⁻ ein Anion ist;
m eine ganze Zahl von 0 oder 1 und n eine ganze Zahl von 1 bis 6 ist; 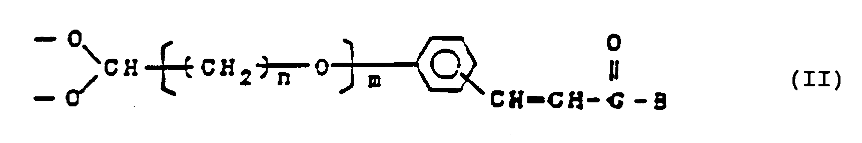 worin B wie in der allgemeinen Formel (III) definiert ist.

3. Lichtempfindliches Material nach Anspruch 1 oder 2, **dadurch gekennzeichnet**, daß B der allgemeinen Formel (II) oder (III) eine aromatische oder heterocyclische Gruppe ist, die mit einer Carbonsäure oder einem Salz davon, einer Sulfonsäure oder einem Salz davon, einem primären, sekundären, tertiären Amin oder einem Salz davon, einschließlich einem quaternären Salz eines tertiären Amins, substituiert ist.

4. Lichtempfindliches Material nach einem der Ansprüche 1 bis 3, **dadurch gekennzeichnet**, daß das Verhältnis der Film-bildenden Polymerverbindung zu dem lichtvernetzbaren Polyvinylalkohol in der lichtempfindlichen Harzzusammensetzung (B) 100 Gew.-Teile: 10 bis 200 Gew.-Teile beträgt.

## Revendications

1. Matériau photosensible pour sérigraphie comprenant :
une composition de résine photosensible (A) appliquée sur une pellicule plastique, et comprenant un polymère ou copolymère soluble dans l'eau ou dispersible dans l'eau, un composé insaturé contenant une liaison double éthylénique photopolymérisable, et un initiateur de photopolymérisation ;
et une composition de résine photosensible (B) appliquée en une épaisseur d'au moins 0,1µm sur la composition appliquée (A) et comprenant un composé polymère filmogène, **caractérisé en ce que** la composition de résine photosensible (B) comprend de plus, un alcool polyvinylique photoréticulable contenant 0,5 à 10 mole % d'une unité photoréticulable de formule générale (III) : 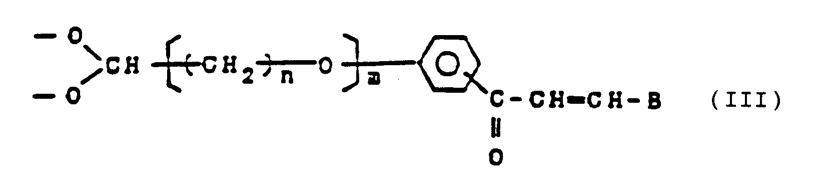 où B est un groupe aromatique ou hétérocyclique contenant au moins une sorte de groupe polaire ; m est un nombre entier de 0 ou 1, et n est un nombre entier de 1 à 6 ;
et où l'alcool polyvinylique utilisé pour la préparation de l'alcool polyvinylique photoréticulable a un degré de saponification de 75 mole % ou plus, et un degré de polymérisation de 300 à 3.000.

2. Matériau photosensible de la revendication 1, dans lequel l'alcool polyvinylique photoréticulable contient de plus une unité photoréticulable de formule générale (I) et/ou (II) : 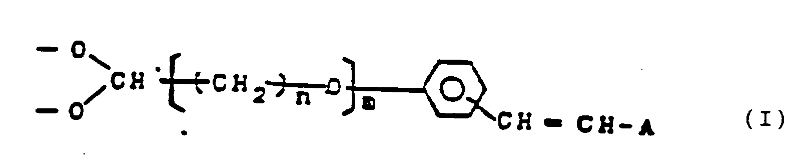 où A est choisi parmi les groupes représentés par les formules générales (1) ou (2) : 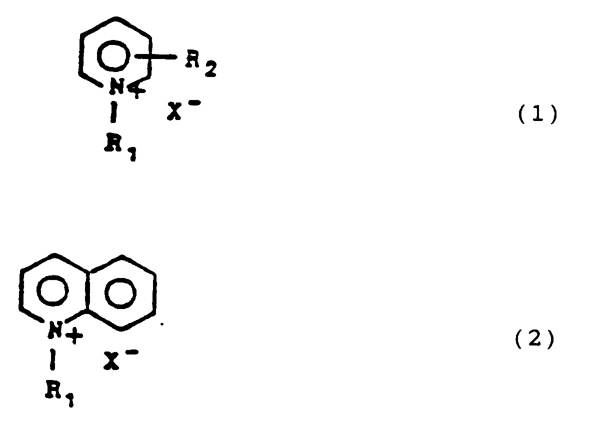 où R₁ est un atome d'hydrogène, ou un groupe alkyle ou aralkyle qui peut contenir un groupe hydroxyle, un groupe carbamoyle, un groupe éther ou un groupe insaturé ; R₂ est un atome d'hydrogène ou un groupe alkyle inférieur ; et X⁻ est un anion ;
m est un nombre entier de 0 ou 1, et n est un nombre entier de 1 à 6 ; 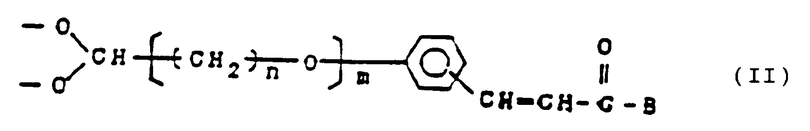 où B est défini comme dans la formule générale (III).

3. Matériau photosensible selon la revendication 1 ou 2, **caractérisé en ce que** B de la formule générale (II) ou (III) est un groupe aromatique ou hétérocyclique substitué par un acide carboxylique ou son sel, un acide sulfonique ou son sel, ou une amine primaire, secondaire, tertiaire ou son sel comprenant un sel quaternaire d'une amine tertiaire.

4. Matériau photosensible selon l'une quelconque des revendications 1 à 3, **caractérisé en ce que** le rapport entre le composé polymère filmogène et l'alcool polyvinylique photoréticulable dans la composition de résine photosensible (B) est de 100 parties en poids : 10 à 200 parties en poids.
